# FASCICULE DE BREVET EUROPEEN

(11) **EP 2 574 689 B1**
(45) Date de publication et mention de la délivrance du brevet: **27.02.2019**
(21) Numéro de dépôt: 12185910.2
(22) Date de dépôt: 25.09.2012
(51) Int. Cl.: C30B 11/00, C30B 35/00, C30B 29/06, C30B 28/06, F27B 14/06, F27B 14/20

(54) **Four de solidification dirigée de cristaux**
Ofen für die gerichtete Erstarrung von Kristallen
Furnace for directional solidification of crystals

(30) Priorité: 28.09.2011 FR 1158702
(43) Date de publication de la demande: 03.04.2013
(73) Titulaire: ECM TECHNOLOGIES, 38000 Grenoble (FR)
(72) Inventeur: ANDROT, Patrick, 38380 SAINT LAURENT DU PONT (FR); LAY, Philippe, 38180 SEYSSINS (FR); REPELLIN, Gilles, 38650 SAINT GUILLAUME (FR); REYMOND, Philippe, 38610 GIERES (FR)
(74) Mandataire: Cabinet Beaumont

(56) Documents cités:
- WO-A1-2011/112926
- WO-A2-2011/037343
- CN-U- 201 962 406
- US-A1- 2009 090 296
- US-A1- 2009 280 050

## Description

### Domaine de l'invention

La présente invention concerne un four de solidification dirigée de cristaux, et plus particulièrement un tel four permettant d'obtenir des lingots de silicium destinés à la fabrication de panneaux solaires photovoltaïques.

### Exposé de l'art antérieur

Le principe de fonctionnement d'un four de solidification dirigée de cristaux est le suivant. Des morceaux de silicium sont introduits dans un creuset en silice. Des éléments de chauffage disposés autour des parois latérales du creuset ou au-dessus du creuset et/ou sous le fond du creuset, permettent ensuite de chauffer le creuset pour faire fondre les morceaux de silicium. Une fois les morceaux de silicium fondus, le creuset est refroidi pour cristalliser le silicium fondu. Le refroidissement du creuset est assuré depuis le fond du creuset, par exemple par un échangeur thermique disposé sous le fond du creuset. La cristallisation du silicium fondu débute alors par le fond du creuset. La solidification est dite dirigée. L'échangeur thermique est par exemple une plaque, disposée sous les éléments de chauffage du fond du creuset et refroidie par circulation d'un fluide.

Après fusion puis cristallisation, un lingot de silicium de structure cristalline différente de celle des morceaux de silicium introduits initialement dans le creuset est obtenu. Généralement, le creuset a une base carrée de l'ordre de 1 m de côté et de 50 cm de hauteur, et on obtient un lingot de silicium de l'ordre de 1 m de côté et de 30 cm de hauteur, destiné à être découpé en briques calibrées.

Afin de limiter la consommation d'énergie du four, il convient, pendant le chauffage et la fusion des morceaux de silicium, de prévoir un blindage thermique entre l'échangeur et les éléments de chauffage du fond du creuset.

Un exemple de blindage thermique pouvant être utilisé est un volet mobile. Pendant les phases de chauffage et de fusion, le volet est positionné entre les éléments de chauffage et l'échangeur thermique. Pour assurer une bonne isolation thermique, le volet est suffisamment grand de façon à s'étendre sous la totalité du fond du creuset. Le volet est ensuite retiré pour commencer la cristallisation. Il faut alors prévoir un système de dégagement complet du volet pour découvrir entièrement l'échangeur thermique.

Un premier inconvénient d'un four équipé d'un blindage thermique tel que celui décrit ci-dessus réside dans son encombrement plus important par rapport à un four sans blindage thermique.

Un autre inconvénient est lié au fait que, lors du dégagement du volet, l'exposition du fond du creuset par rapport à l'échangeur thermique débute à partir d'un bord du fond du creuset. La cristallisation du silicium fondu tend alors à commencer par un des bords du creuset. Pour obtenir une cristallisation uniforme du silicium fondu, il convient alors de dégager le volet le plus rapidement possible. Toutefois, pour certaines applications, il est préférable d'augmenter progressivement la surface du fond du creuset exposée à l'échangeur thermique. Dans un four équipé d'un blindage thermique du type de celui décrit ci-dessus, ceci se ferait au détriment de la qualité de la cristallisation du silicium fondu.

La demande de brevet US 2009/0280050 décrit un four équipé d'un blindage thermique muni de quatre volets mobiles disposés dans un même plan.

Le modèle d'utilité CN201962406 U décrit un four équipé de quatre volets mobiles en translation en direction d'un axe de symétrie, les volets étant mis en translation par des valves pneumatiques.

Il existe donc un besoin d'un four de solidification dirigée de cristaux équipé d'un blindage thermique palliant au moins en partie certains des inconvénients des fours équipés d'un blindage thermique du type de celui décrit ci-dessus. Résumé

Ainsi, un objet d'un mode de réalisation de la présente invention est de prévoir un four de solidification dirigée de cristaux équipé d'un blindage thermique présentant un encombrement réduit.

Un autre objet d'un mode de réalisation de la présente invention est de prévoir un four de solidification dirigée de cristaux équipé d'un blindage thermique permettant, pendant les phases de cristallisation, d'augmenter la surface du fond du creuset exposée à l'échangeur thermique à partir du centre du creuset.

Un autre objet d'un mode de réalisation de la présente invention est de prévoir un four de solidification dirigée de cristaux équipé d'un blindage thermique permettant, pendant les phases de cristallisation, d'augmenter progressivement la surface du fond du creuset exposée à l'échangeur thermique.

Un mode de réalisation de la présente invention prévoit un four de solidification dirigée de cristaux comprenant un creuset, le creuset étant destiné à contenir les cristaux et comportant un axe de symétrie, le four comprenant successivement, selon l'axe de symétrie : le creuset ; des éléments de chauffage ; un blindage thermique ; un échangeur thermique ; le blindage thermique comprenant successivement, selon l'axe de symétrie, deux premiers volets et deux seconds volets, les premiers volets pouvant s'écarter et se rapprocher l'un de l'autre et de l'axe de symétrie par des mouvements de translation, et les seconds volets pouvant s'écarter et se rapprocher l'un de l'autre et de l'axe de symétrie par des mouvements de translation, les directions de translation des premiers volets et des seconds volets étant orthogonales.

Selon un mode de réalisation de la présente invention, le blindage thermique comprend des supports, chaque premier et second volet étant fixé sur un support, les supports étant adaptés à coulisser sur une plaque disposée entre les volets et l'échangeur thermique.

Selon un mode de réalisation de la présente invention, lorsque les premiers volets sont rapprochés au maximum l'un de l'autre et les seconds volets sont rapprochés au maximum l'un de l'autre, chaque second volet est positionné au moins en partie entre chaque premier volet et le support associé.

Selon un mode de réalisation de la présente invention, chaque premier et second volet a une forme rectangulaire et chaque support comprend une portion pointue dirigée vers l'axe de symétrie.

Selon un mode de réalisation de la présente invention, les premiers volets sont adaptés à venir en contact l'un de l'autre et les seconds volets sont adaptés à venir en contact l'un de l'autre, et un côté de la portion pointue de l'un des supports associés aux premiers volets est adapté à venir en contact avec un côté de la portion pointue de l'un des supports associés aux seconds volets.

Selon un mode de réalisation de la présente invention, chaque premier volet est écarté du support associé, d'une distance égale à l'épaisseur de l'un des seconds volets, par des éléments d'écartement.

Selon un mode de réalisation de la présente invention, pour chaque premier volet, les éléments d'écartement comprennent une entretoise reliant le bord du premier volet le plus éloigné de l'axe de symétrie et le support associé, et une tige reliant le bord du premier volet le plus proche de l'axe de symétrie et la portion pointue du support associé, et chaque second volet comprend des ouvertures adaptées à recevoir les tiges lorsque les volets sont rapprochés au maximum l'un de l'autre.

Selon un mode de réalisation de la présente invention, le blindage thermique comprend un système d'entraînement adapté à écarter et rapprocher les premiers et seconds volets, l'échangeur thermique étant disposé entre les premiers et seconds volets d'une part et au moins une partie du système d'entraînement d'autre part.

Selon un mode de réalisation de la présente invention, le système d'entraînement comprend une pièce d'entraînement reliée à chaque premier et second volet par l'intermédiaire d'une bielle articulée par rapport à la pièce d'entraînement et par rapport au premier ou second volet associé, le système d'entraînement comprenant en outre un moteur adapté à entraîner la pièce d'entraînement en rotation autour de l'axe de symétrie.

Selon un mode de réalisation de la présente invention, ce four comprend en outre, pour chaque premier et second volet, une pièce de liaison allongée fixée au bord du premier ou second volet associé le plus éloigné de l'axe de symétrie, la pièce de liaison allongée étant orientée suivant une direction parallèle à l'axe de symétrie, et la bielle étant articulée par rapport à la pièce de liaison et par rapport à la pièce d'entraînement et orientée suivant une direction orthogonale à l'axe de symétrie.

Un mode de réalisation de la présente invention prévoit en outre un procédé de fabrication d'un lingot d'un matériau cristallin, mettant en oeuvre le four décrit ci-dessus, comprenant les étapes suivantes : a) introduire des morceaux du matériau dans le creuset ; b) faire fondre les morceaux du matériau par les éléments de chauffage, les premiers volets étant rapprochés au maximum l'un de l'autre et les seconds volets étant rapprochés au maximum l'un de l'autre ; c) refroidir le matériau fondu par l'échangeur thermique en écartant les premiers volets l'un de l'autre et les seconds volets l'un de l'autre, pour amener le matériau fondu à se solidifier et former le lingot.

Selon un mode de réalisation de la présente invention : à l'étape a), des germes monocristallins sont introduits dans le creuset en plus des morceaux du matériau, au moins une partie des germes monocristallins ne fondant pas à l'étape b); et à l'étape c), la solidification du matériau fondu est amorcée à partir de la partie des germes monocristallins qui n'a pas fondu à l'étape b).

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe illustrant de façon schématique un four de solidification dirigée de cristaux comprenant un blindage thermique ;
les figures 2 et 3 sont des vues en perspective avec coupe de la partie inférieure du four illustré en figure 1 lorsque le blindage thermique est respectivement en position ouverte et fermée ;
la figure 4 est une vue analogue à la figure 3, certains éléments de la figure 3 n'étant pas représentés ;
les figures 5 et 6 sont des vues de dessus de la partie inférieure du four illustré en figure 1 lorsque le blindage thermique est respectivement en position ouverte et fermée ; et
les figures 7 et 8 sont des vues analogues respectivement aux figures 5 et 6, dans lesquelles certains éléments des figures 5 et 6 ne sont pas représentés.

### Description détaillée

Par souci de clarté, de mêmes éléments ont été désignés par de mêmes références dans les différentes figures. En outre, seuls les éléments nécessaires à la compréhension de l'invention ont été décrits.

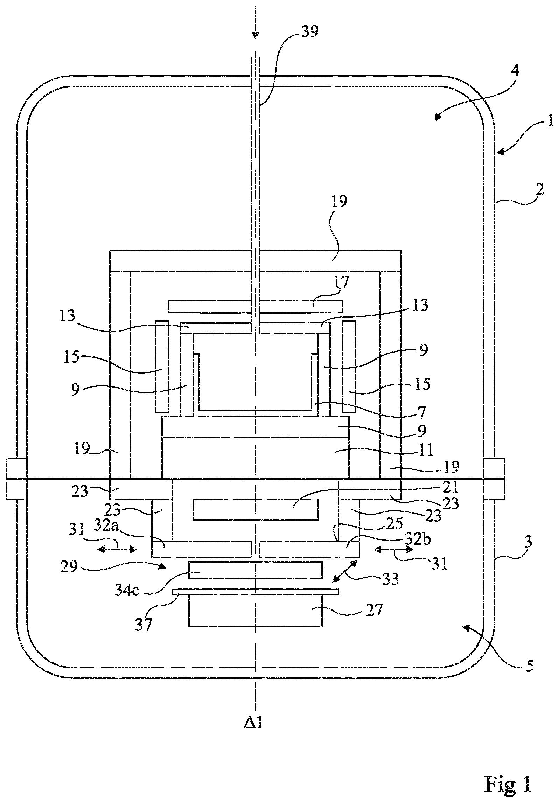

La figure 1 est une vue en coupe illustrant de façon schématique un four de solidification dirigée de cristaux.

Le four comprend une enceinte 1, par exemple une enceinte cylindrique à double paroi d'axe Δ1, par exemple vertical. Dans la suite de la description, les adjectifs "supérieur" et "inférieur" sont utilisés en relation avec l'axe Δ1. Le plan de coupe correspond à un plan de symétrie contenant l'axe Δ1. Le diamètre extérieur de l'enceinte 1 est par exemple de 2 mètres. L'enceinte 1 est généralement refroidie par un système de mise en circulation d'un fluide, non représenté. L'enceinte 1 comprend une enceinte supérieure 2 et une enceinte inférieure 3, délimitant respectivement une partie supérieure 4 du four et une partie inférieure 5 du four.

En fonctionnement, la partie supérieure 4 du four comprend un creuset 7, par exemple en silice. Le creuset est par exemple de base carrée, par exemple de 88 cm de côté et de 42 cm de hauteur. Des plaques 9 sont fixées aux parois latérales et au fond du creuset 7. Les plaques 9 servent notamment à augmenter la rigidité du creuset 7. La plaque 9 sur laquelle repose le fond du creuset 7 est elle-même posée sur un support 11. Une plaque 13 recouvre le haut du creuset 7. Les plaques 9 et 13 et le support 11 sont en un matériau conducteur thermique, par exemple en graphite.

Des éléments de chauffage 15 sont disposés autour des plaques 9 entourant les parois latérales du creuset 7, et un élément de chauffage 17 est disposé au-dessus de la plaque 13 recouvrant le creuset 7. Des éléments isolants 19 entourent l'ensemble constitué par le creuset 7, les plaques 9 et 13, les éléments de chauffage 15 et 17, et le support 11.

Des éléments de chauffage 21 sont disposés sous le support 11, dans la partie inférieure 5 du four. Les éléments de chauffage 15, 17 et 21 sont par exemple constitués de résistances électriques comprenant par exemple plusieurs barreaux de chauffage.

Des éléments isolants 23 sont placés dans la partie inférieure 5 du four et délimitent avec les éléments isolants 19 une enceinte interne entourant le creuset 7 et comportant une ouverture 25 sous les éléments de chauffage 21.

Un échangeur thermique 27 est disposé sous les éléments de chauffage 21. L'échangeur thermique 27 est par exemple une plaque refroidie par circulation d'un fluide. L'échangeur thermique 27 peut aussi correspondre à une portion de l'enceinte inférieure 3.

Le four comprend un blindage thermique 29, disposé entre les éléments de chauffage 21 et l'échangeur thermique 27, et comprenant deux volets supérieurs 32a et 32b, et deux volets inférieurs 34c et 34d (seul le volet 34c étant visible en figure 1).

Les deux volets supérieurs 32a et 32b sont disposés sous les éléments de chauffage 21. Les deux volets inférieurs 34c et 34d sont disposés sous les volets 32a et 32b. Les volets 32a, 32b, 34c et 34d sont en un matériau isolant thermique, par exemple en feutre de graphite. Les volets 32a, 32b, 34c et 34d sont disposés orthogonalement à l'axe Δ1. Les volets supérieurs 32a, 32b peuvent être éloignés ou rapprochés l'un de l'autre par un mouvement de translation selon une direction orthogonale à l'axe Δ1 et contenue dans le plan de coupe (doubles flèches 31). Les volets inférieurs 34c, 34d peuvent être éloignés ou rapprochés l'un de l'autre par un mouvement de translation selon une direction orthogonale à l'axe Δ1 et perpendiculaire au plan de coupe (double flèche 33). Une plaque 37, en un matériau conducteur thermique, par exemple en graphite, recouvre l'échangeur 27.

Le four comprend en outre un conduit 39 destiné à l'injection d'un gaz inerte, par exemple de l'argon, à l'intérieur de l'enceinte 1 du four.

Le fonctionnement d'un tel four de solidification dirigée de cristaux est le suivant.

La partie inférieure 5 du four est éloignée de la partie supérieure 4 du four. Le creuset 7 contenant des morceaux de silicium est mis en place dans le four. L'enceinte 1 du four est ensuite refermée en rapprochant la partie inférieure 5 de la partie supérieure 4 du four.

Afin de faire fondre les morceaux de silicium contenus dans le creuset 7, une température supérieure à la température de fusion du silicium (environ 1420°C), par exemple une température de l'ordre de 1500°C, est appliquée dans le creuset 7 par les éléments de chauffage 15, 17 et 21. Les phases de chauffage et de fusion du silicium peuvent durer par exemple environ 12 heures.

Pendant les phases de chauffage et de fusion du silicium, les volets 32a, 32b, 34c et 34d sont positionnés entre les éléments de chauffage 21 et l'échangeur thermique 27, de façon à fermer l'ouverture 25. Les pertes thermiques lors du chauffage du creuset 7 sont ainsi réduites. Dans la suite de la description, les volets 32a, 32b, 34c et 34d sont alors dits en position fermée.

Une fois les morceaux de silicium fondus, les éléments de chauffage 21 sont arrêtés. Les volets 32a, 32b, 34c et 34d sont dégagés pour découvrir l'ouverture 25. Dans la suite de la description, les volets 32a, 32b, 34c et 34d sont alors dits en position ouverte. Le fond du creuset 7 est refroidi par l'échangeur thermique 27. La phase de cristallisation du silicium peut durer environ 24 heures, et la vitesse de cristallisation du silicium est par exemple de quelques millimètres par heure. Pendant toute la phase de cristallisation, la température est maintenue à environ 1420°C au sommet du creuset 7.

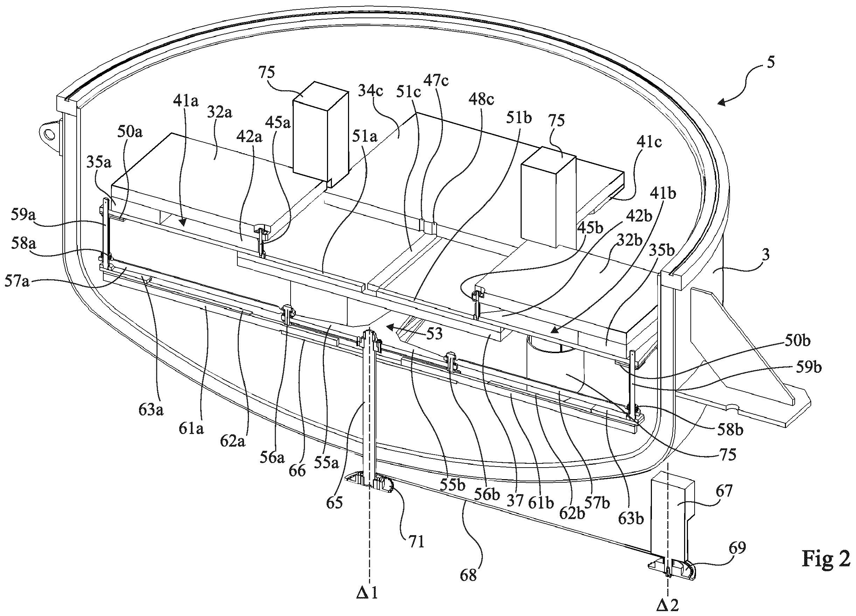

Un exemple de réalisation d'un blindage thermique tel que celui décrit en relation avec la figure 1 est décrit plus précisément dans la suite de la description en relation avec les figures 2 à 8.

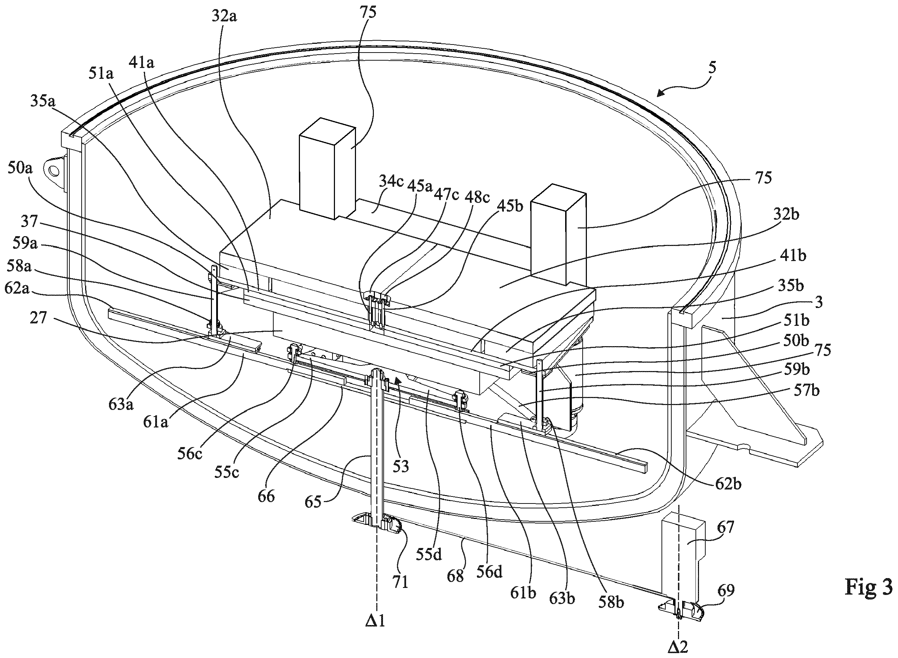

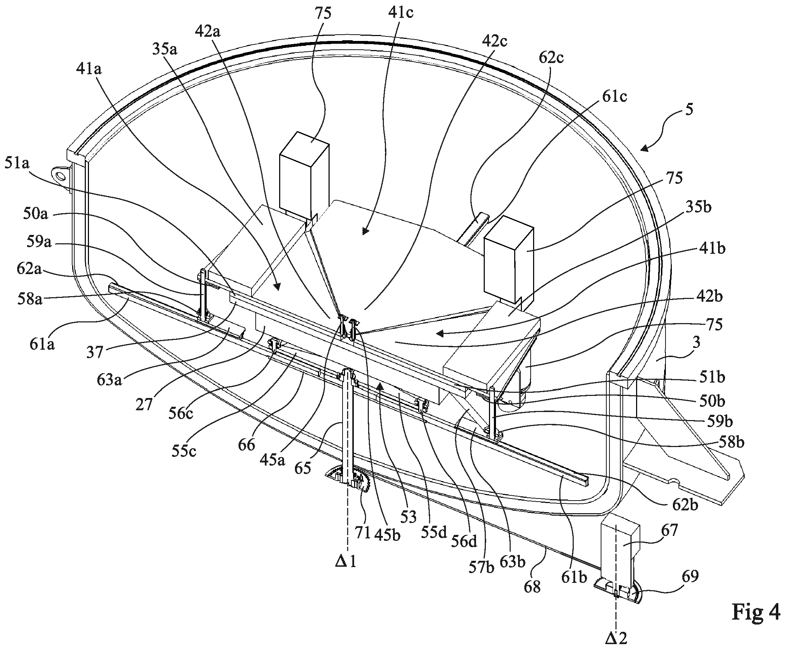

Les figures 2 et 3 sont des vues en perspective avec coupe de la partie inférieure 5 du four, et correspondent respectivement aux positions ouverte et fermée des volets. La figure 4 est une vue analogue à la figure 3, dans laquelle certaines pièces de la figure 3 ne sont pas représentées. La coupe des figures 2 à 4 a été réalisée suivant un plan de symétrie du four contenant l'axe Δ1. L'échangeur 27 est représenté en figures 3 et 4, mais pas en figure 2.

Les volets supérieurs 32a et 32b et le volet inférieur 34c sont représentés sur les figures 2 et 3. Le volet inférieur 34d n'est pas représenté sur ces figures. Les volets 32a, 32b, 34c et 34d sont tous identiques, et ont par exemple une forme rectangulaire en vue de dessus. Chaque volet 32a, 32b, 34c et 34d est associé à un support 41a, 41b, 41c, 41d respectivement. Les supports 41a à 41d sont par exemple en graphite. Les supports 41a à 41d peuvent être en un matériau différent de celui des volets 32a, 32b, 34c, 34d, par exemple en un matériau plus rigide que celui des volets. En outre, le matériau constituant les supports 41a à 41d peut être choisi de façon à avoir une bonne tenue à la température. La figure 4 illustre plus particulièrement les supports 41a à 41c, les volets n'étant pas représentés sur cette figure. Chaque support 41a à 41d correspond à une plaque plane disposée de façon orthogonale par rapport à l'axe Δ1. Chaque support 41a à 41d comprend une portion pointue 42a à 42d dirigée vers l'axe du four Δ1 et qui, en vue de dessus, a la forme générale d'un triangle isocèle. Les quatre supports 41a à 41d sont au même niveau. Lorsque les volets 32a, 32b, 34c, 34d sont en position fermée, chaque portion pointue 42a et 42b est adjacente à deux portions pointues 42c et 42d. Les extrémités des portions pointues 42a à 42d sont alors sensiblement sur l'axe Δ1.

Chaque volet supérieur 32a et 32b est écarté du support associé 41a et 41b par des éléments d'écartement. Les éléments d'écartement comprennent une entretoise 35a, 35b, qui est située entre le volet 32a, 32b et le support 41a, 41b associé, au niveau du bord du volet 32a, 32b le plus éloigné de l'axe Δ1. L'entretoise 35a, 35b est fixée au volet supérieur 32a, 32b et au support 41a, 41b associé par des moyens non représentés. Chaque entretoise 35a et 35b a une épaisseur sensiblement identique à celle des volets 34c et 34d. Les éléments d'écartement comprennent en outre, pour chaque volet 32a et 32b, une tige 45a et 45b, d'axe parallèle à l'axe Δ1, fixée à une extrémité au bord du volet 32a, 32b le plus proche de l'axe Δ1 et fixée à l'extrémité opposée à la portion pointue 42a, 42b du support 41a, 41b associé. Chaque volet 34c, 34d comprend deux ouvertures 47c, 47d et 48c, 48d ayant la forme d'un demi-cylindre d'axe parallèle à l'axe Δ1.

A chaque support 41a à 41d est associé un rail 51a à 51d, disposé sous le support 41a à 41d correspondant, et fixé à la plaque 37 recouvrant l'échangeur thermique 27. Le support 41a à 41d associé à chaque volet est adapté à coulisser sur le rail 51a à 51d associé. Le matériau constituant les supports 41a à 41d peut être choisi pour faciliter le coulissement des supports 41a à 41d sur les rails 51a à 51d associés.

Le blindage thermique comprend en outre des éléments d'entraînement, situés pour la majeure partie sous l'échangeur thermique 27. Les éléments d'entraînement comprennent une pièce d'entraînement 53. La pièce d'entraînement 53 comprend un centre de symétrie situé sur l'axe du four Δ1. La pièce d'entraînement 53 comprend quatre bras 55a à 55d, l'extrémité de chaque bras 55a à 55d étant reliée à un support 41a à 41d, par l'intermédiaire d'une bielle 57a à 57d et d'une pièce de liaison 59a à 59d. Pour chaque volet 32a, 32b, 34c, 34d, une pièce d'appui 50a à 50d est fixée sous le support 41a à 41d associé, au niveau de l'extrémité du support le plus éloigné de l'axe du four Δ1. Chaque volet 32a, 32b, 34c, 34d et le support associé 41a à 41d sont fixés à la pièce d'appui 50a à 50d par des éléments non représentés. Chaque pièce de liaison 59a à 59d est fixée à la pièce d'appui 50a à 50d, sensiblement au milieu de la pièce d'appui 50a à 50d. Chaque pièce de liaison 59a à 59d a une forme cylindrique orientée suivant une direction parallèle à l'axe Δ1. Chaque bielle 57a à 57d est reliée à la pièce de liaison 59a à 59d associée par un élément d'articulation 58a à 58d, et est reliée à l'extrémité du bras 55a à 55d associé de la pièce d'entraînement 53 par un élément d'articulation 56a à 56d. Chaque bielle 57a à 57d est orientée suivant une direction orthogonale à l'axe Δ1. Chaque élément d'articulation 56a à 56d et 58a à 58d peut être une liaison à pivot autour d'un axe parallèle à l'axe Δ1. Des guides 61a à 61d rectilignes sont disposés sous l'ensemble constitué par la pièce d'entraînement 53, les bielles 57a à 57d et les pièces de liaison 59a à 59d. Les guides 61a, 61b sont orientés selon un axe horizontal situé dans l'un des plans de symétrie du four. Les guides 61c, 61d sont orientés selon un axe horizontal situé dans l'autre plan de symétrie du four. Un système à roulements 62a à 62d est prévu sur chaque guide 61a à 61d. L'extrémité de chaque pièce de liaison 59a à 59d, qui n'est pas fixée à la pièce d'appui 50a à 50d associée, est fixée à un chariot 63a à 63d adapté à coulisser sur le système à roulements 62a à 62d correspondant. Les guides 61a à 61d reposent au niveau de leur extrémité la plus proche de l'axe Δ1 sur une plaque d'appui 66.

La pièce d'entraînement 53 est en outre fixée, au niveau de sa partie centrale, à un arbre 65 monté libre en rotation selon l'axe Δ1 sur l'enceinte inférieure 3 du four par des paliers non représentés. L'arbre 65 est entraîné en rotation autour de l'axe Δ1 par un moteur 67. L'arbre du moteur 67 est adapté à tourner autour d'un axe Δ2 parallèle à l'axe Δ1. Des roues dentées 69 et 71 et une chaîne 68 permettent de transmettre le mouvement de rotation du moteur 67 à l'arbre 65. Le moteur 67 est adapté à entraîner en rotation l'arbre 65 de façon continue ou par paliers successifs. La position angulaire de l'arbre 65 peut être déterminée à partir de signaux de commande du moteur 67.

Des supports 75 destinés à recevoir le creuset 7 sont en outre représentés sur les différentes figures.

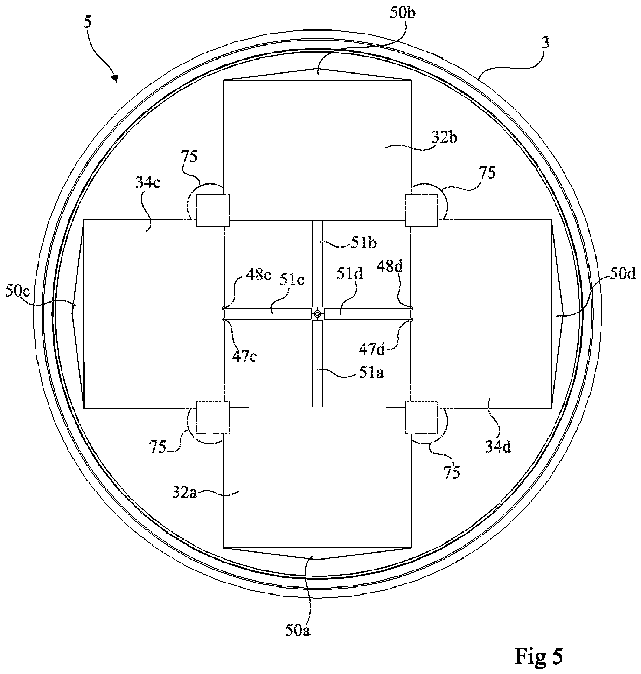

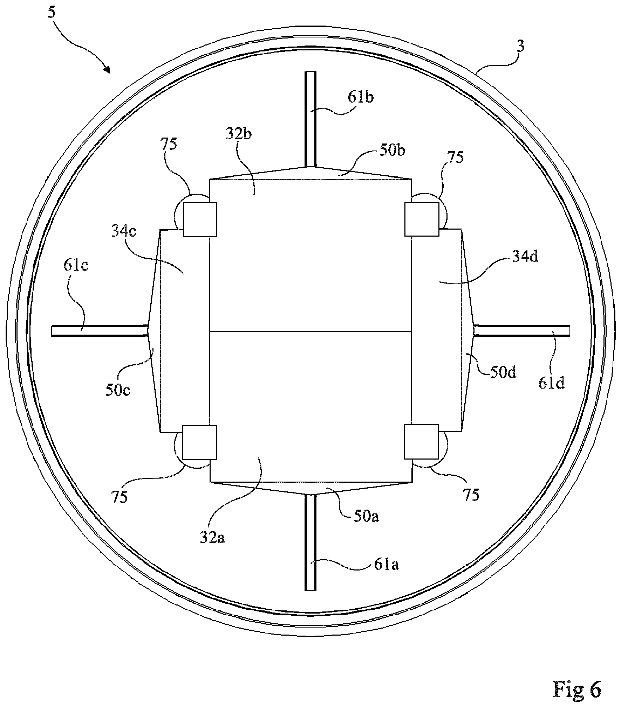

Les figures 5 et 6 sont des vues de dessus de la partie inférieure 5 du four, illustrant plus particulièrement les quatre volets 32a, 32b, 34c et 34d du blindage thermique, respectivement en position ouverte et fermée.

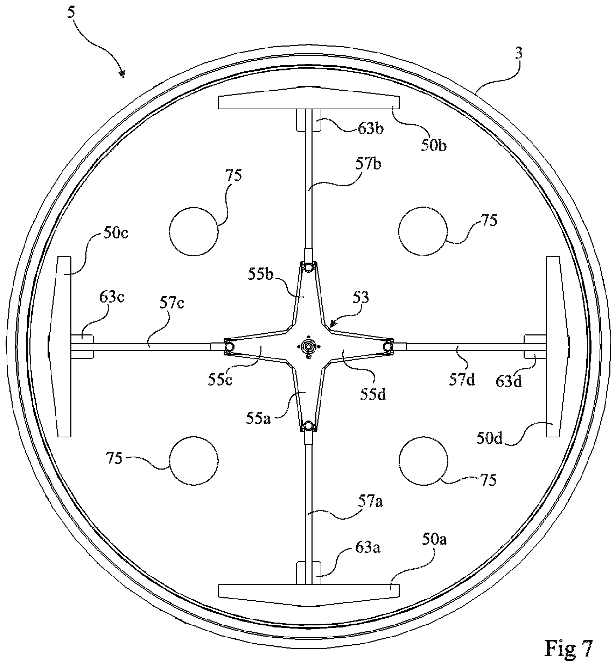

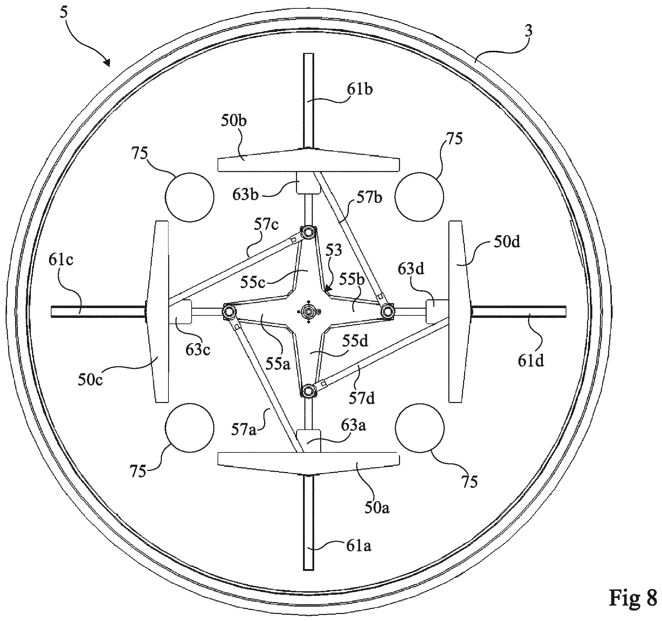

Les figures 7 et 8 sont des vues de dessus de la partie inférieure 5 du four correspondant aux figures 5 et 6, les volets 32a, 32b, 34c et 34d n'étant pas représentés.

Le fonctionnement d'un blindage thermique du type de celui décrit en relation avec les figures 1 à 8 est le suivant.

Pendant les phases de chauffage et de fusion du silicium contenu dans le creuset 7, les volets du blindage thermique sont en position fermée, ce qui correspond aux figures 3, 4, 6 et 8. Chaque volet inférieur 34c, 34d est positionné pour sa majeure partie entre chaque volet supérieur 32a, 32b et le support associé 41a, 41b. Les volets supérieurs 32a et 32b d'une part, et les volets inférieurs 34c et 34d d'autre part, sont en contact l'un de l'autre selon un bord. La tige 45a associée au volet supérieur 32a est insérée dans les ouvertures 47c et 47d des volets inférieurs 34c et 34d respectivement. La tige 45b associée au volet supérieur 32b est insérée dans les ouvertures 48c et 48d des volets inférieurs 34c et 34d respectivement. Le fond du creuset 7 est ainsi isolé de l'échangeur thermique 27.

Pour assurer une bonne isolation thermique, des dimensions suffisantes des volets sont prévues de façon qu'ils s'étendent sous la totalité du fond du creuset lorsqu'ils sont en position fermée. A titre d'exemple, pour un creuset de base carrée de 90 cm de côté, la longueur des volets peut être de l'ordre de 1 m, et leur largeur peut être de l'ordre de 50 cm.

Une fois les phases de chauffage et de fusion terminées, les deux volets supérieurs 32a, 32b d'une part, et les deux volets inférieurs 34c, 34d d'autre part, sont écartés progressivement l'un de l'autre, et de façon simultanée. Une fois écartés au maximum, les volets 32a, 32b, 34c, 34d du blindage thermique sont en position ouverte, ce qui correspond aux figures 2, 5 et 7.

Pour passer de la position fermée des volets à la position ouverte, le moteur 67 entraîne la pièce d'entraînement 53 en rotation d'un quart de tour autour de l'axe Δ1. La rotation de la pièce 53 entraîne le déplacement des bielles 57a à 57d, qui elles-mêmes entraînent le déplacement des chariots 63a à 63d. Chaque chariot 63a à 63d coulisse alors sur le guide 61a à 61d associé, en s'éloignant de l'axe Δ1. Chaque chariot 63a à 63d entraîne en translation le volet 32a, 32b, 34c, 34d et le support associé 41a à 41d, par l'intermédiaire de la pièce de liaison 59a à 59d et de la pièce d'appui 50a à 50d. Chaque support 41a à 41d coulisse sur le rail 51a à 51d associé en s'éloignant de l'axe Δ1. Les deux volets supérieurs 32a, 32b d'une part, et les deux volets inférieurs 34c et 34d d'autre part, s'écartent ainsi l'un de l'autre, et de l'axe Δ1. Le mouvement de rotation de la pièce d'entraînement 53 est donc transformé en un mouvement de translation simultané de chaque volet 32a, 32b, 34c, 34d, les directions de translation des volets supérieurs 32a, 32b d'une part, et des volets inférieurs 34c, 34d d'autre part, étant orthogonales. La surface du fond du creuset 7 exposée à l'échangeur thermique 27 est ainsi augmentée à partir du centre du creuset 7 jusqu'à ce que la totalité du fond du creuset 7 soit exposée à l'échangeur thermique 27.

Pour passer de la position ouverte des volets à la position fermée, le moteur 67 entraîne la pièce d'entraînement 53 en rotation d'un quart de tour autour de l'axe Δ1, dans le sens inverse par rapport au sens de rotation utilisé lors du passage précédent de la position fermée à la position ouverte des volets. La rotation de la pièce d'entraînement 53 entraîne le déplacement des bielles 57a à 57d, qui elles-mêmes entraînent le déplacement des chariots 63a à 63d. Chaque chariot 63a à 63d coulisse alors sur le guide 61a à 61d associé, en se rapprochant de l'axe Δ1. Chaque chariot 63a à 63d entraîne en translation le volet 32a, 32b, 34c, 34d et le support associé 41a à 41d, par l'intermédiaire de la pièce de liaison 59a à 59d et de la pièce d'appui 50a à 50d. Chaque support 41a à 41d coulisse sur le rail 51a à 51d associé en se rapprochant de l'axe Δ1. Les deux volets supérieurs 32a et 32b d'une part, et les deux volets inférieurs 34c et 34d d'autre part, se rapprochent ainsi l'un de l'autre, et de l'axe Δ1, jusqu'à venir en contact l'un de l'autre.

Un four de solidification dirigée comprenant un blindage thermique tel que celui décrit ci-dessus présente plusieurs avantages.

Un avantage réside dans l'encombrement réduit d'un tel four. Les quatre volets, chacun ayant une aire légèrement supérieure à la moitié de l'aire du fond du creuset, peuvent être écartés simultanément pour découvrir entièrement l'échangeur thermique, tout en entraînant un encombrement inférieur à celui qui serait nécessaire avec un volet unique se dégageant latéralement. De plus, le système d'entraînement du blindage thermique lui-même présente un encombrement réduit. En effet, il est situé pour sa majeure partie sous l'échangeur thermique. De plus, il permet le pilotage centralisé des quatre volets du blindage thermique par un seul moteur.

Un autre avantage réside dans le fait que la commande du moteur est particulièrement simple puisque la synchronisation des mouvements de translation des quatre volets lors du passage de la position fermée à la position ouverte et inversement est assurée par un assemblage de pièces mécaniques.

Un autre avantage d'un tel four réside dans le contrôle de la cristallisation. Pendant les phases de cristallisation, les quatre volets du blindage thermique sont écartés simultanément l'un de l'autre, et à partir de l'axe du four. Ainsi, la cristallisation du silicium fondu est amorcée à partir du centre du creuset. Ceci permet d'améliorer la cristallisation pour des applications photovoltaïques. De plus, la vitesse de rotation du moteur 67 entraînant la pièce d'entraînement 53 peut être choisie de façon que les volets supérieurs 32a, 32b d'une part, et inférieurs 34c, 34d d'autre part, s'écartent l'un de l'autre très lentement. Ceci permet d'augmenter progressivement la surface du fond du creuset exposée à l'échangeur thermique. Un meilleur contrôle de la structure cristalline du lingot de silicium est ainsi obtenu. L'augmentation progressive de la surface du fond du creuset exposée à l'échangeur thermique, à partir du centre du creuset, permet d'améliorer le contrôle de la forme du front de cristallisation.

Un tel four est particulièrement bien adapté à la fabrication de lingots de silicium multicristallins contenant des monocristaux de taille importante, c'est-à-dire à la fabrication de lingots de silicium dits "quasi-monocristallins" (en anglais "monolike"). Dans ce cas, des germes monocristallins sont introduits dans le fond du creuset en même temps que les morceaux de silicium, qui sont généralement polycristallins. Les volets sont ouverts avant que les germes monocristallins aient entièrement fondu avec les morceaux de silicium. La cristallisation du silicium est ainsi amorcée à partir des germes monocristallins. L'augmentation progressive de la surface du fond du creuset exposée à l'échangeur thermique, à partir du centre du creuset, permet de maîtriser la croissance cristalline du lingot de silicium quasi-monocristallin.

Des modes de réalisation particuliers de la présente invention ont été décrits. Diverses variantes et modifications apparaîtront à l'homme de l'art. En particulier, bien qu'on ait décrit ci-dessus le fonctionnement d'un four de solidification dirigée de cristaux dans le cas particulier de cristaux de silicium, un four de solidification dirigée de cristaux tel que celui décrit en relation avec les figures 1 à 8 peut être utilisé pour fabriquer d'autres types de cristaux. En outre, des éléments de chauffage autres que des résistances électriques, par exemple des éléments de chauffage à induction, peuvent être utilisés. De plus, bien qu'on ait décrit ci-dessus un blindage thermique comprenant deux volets supérieurs et deux volets inférieurs, le blindage thermique peut comprendre plusieurs empilements de volets. En outre, chaque volet peut être constitué de deux volets à deux niveaux différents, l'un des volets ayant un débattement plus important que l'autre.

## Revendications

1. Four de solidification dirigée de cristaux comprenant un creuset (7), le creuset étant destiné à contenir les cristaux et comportant un axe de symétrie (Δ1), le four comprenant successivement, selon l'axe de symétrie (Δ1) :
le creuset (7);
des éléments de chauffage (21) ;
deux premiers volets (32a, 32b), situés dans un premier plan, pouvant s'écarter et se rapprocher l'un de l'autre et de l'axe de symétrie par des mouvements de translation ;
deux seconds volets (34c, 34d), situés dans un second plan, pouvant s'écarter et se rapprocher l'un de l'autre et de l'axe de symétrie (Δ1) par des mouvements de translation, les directions de translation des premiers volets (32a, 32b) et des seconds volets (34c, 34d) étant orthogonales, l'ensemble des premiers et seconds volets (32a, 32b, 34c, 34d) constituant un blindage thermique (29) ;
un système d'entraînement, adapté à écarter et rapprocher les premiers et seconds volets (32a, 32b, 34c, 34d), comprenant une pièce d'entraînement (53) reliée à chaque premier et second volet (32a, 32b, 34c, 34d) par l'intermédiaire d'une bielle (57a à 57d) articulée par rapport à la pièce d'entraînement (53) et par rapport au premier ou second volet associé, le système d'entraînement comprenant en outre un moteur (67) adapté à entraîner la pièce d'entraînement (53) en rotation autour de l'axe de symétrie (Δ1) ; et
un échangeur thermique (27).

2. Four selon la revendication 1, dans lequel le blindage thermique (29) comprend des supports (41a à 41d), chaque premier et second volet (32a, 32b, 34c, 34d) étant fixé sur un support, les supports étant adaptés à coulisser sur une plaque (37) disposée entre les volets et l'échangeur thermique (27) .

3. Four selon la revendication 2, dans lequel, lorsque les premiers volets (32a, 32b) sont rapprochés au maximum l'un de l'autre et les seconds volets (34c, 34d) sont rapprochés au maximum l'un de l'autre, chaque second volet (34c, 34d) est positionné au moins en partie entre chaque premier volet (32a, 32b) et le support associé (41a, 41b).

4. Four selon la revendication 2 ou 3, dans lequel chaque premier et second volet (32a, 32b, 34c, 34d) a une forme rectangulaire et chaque support (41a à 41d) comprend une portion pointue (42a à 42d) dirigée vers l'axe de symétrie (Δ1).

5. Four selon la revendication 4, dans lequel les premiers volets (32a, 32b) sont adaptés à venir en contact l'un de l'autre et les seconds volets (34c, 34d) sont adaptés à venir en contact l'un de l'autre, et dans lequel un côté de la portion pointue (42a, 42b) de l'un des supports (41a, 41b) associés aux premiers volets est adapté à venir en contact avec un côté de la portion pointue (42c, 42d) de l'un des supports (41c, 41d) associés aux seconds volets.

6. Four selon la revendication 2, dans lequel chaque premier volet (32a, 32b) est écarté du support associé (41a, 41b), d'une distance égale à l'épaisseur de l'un des seconds volets (34c, 34d), par des éléments d'écartement (35a, 35b, 45a, 45b) .

7. Four selon la revendication 6, dans lequel, pour chaque premier volet (32a, 32b), les éléments d'écartement comprennent une entretoise (35a, 35b) reliant le bord du premier volet le plus éloigné de l'axe de symétrie (Δ1) et le support (41a, 41b) associé, et une tige (45a, 45b) reliant le bord du premier volet le plus proche de l'axe de symétrie et la portion pointue (42a, 42b) du support associé, et dans lequel chaque second volet (34c, 34d) comprend des ouvertures (47c, 47d, 48c, 48d) adaptées à recevoir les tiges lorsque les volets sont rapprochés au maximum l'un de l'autre.

8. Four selon l'une quelconque des revendications 1 à 7, dans lequel l'échangeur thermique (27) est disposé entre les premiers et seconds volets d'une part et au moins une partie du système d'entraînement d'autre part.

9. Four selon l'une quelconque des revendications 1 à 8, comprenant en outre, pour chaque premier et second volet (32a, 32b, 34c, 34d), une pièce de liaison allongée (59a à 59d) fixée au bord du premier ou second volet associé le plus éloigné de l'axe de symétrie (Δ1), la pièce de liaison allongée étant orientée suivant une direction parallèle à l'axe de symétrie, et la bielle (57a à 57d) étant articulée par rapport à la pièce de liaison et par rapport à la pièce d'entraînement (53) et orientée suivant une direction orthogonale à l'axe de symétrie.

10. Procédé de fabrication d'un lingot d'un matériau cristallin, mettant en oeuvre le four selon l'une quelconque des revendications 1 à 9, comprenant les étapes suivantes :
a) introduire des morceaux du matériau dans le creuset (7) ;
b) faire fondre les morceaux du matériau par les éléments de chauffage (21), les premiers volets (32a, 32b) étant rapprochés au maximum l'un de l'autre et les seconds volets (34c, 34d) étant rapprochés au maximum l'un de l'autre ;
c) refroidir le matériau fondu par l'échangeur thermique (27) en écartant les premiers volets (32a, 32b) l'un de l'autre et les seconds volets (34c, 34d) l'un de l'autre, pour amener le matériau fondu à se solidifier et former le lingot.

11. Procédé selon la revendication 10, dans lequel :
à l'étape a), des germes monocristallins sont introduits dans le creuset (7) en plus des morceaux du matériau, au moins une partie des germes monocristallins ne fondant pas à l'étape b); et
à l'étape c), la solidification du matériau fondu est amorcée à partir de la partie des germes monocristallins qui n'a pas fondu à l'étape b).

## Patentansprüche

1. Ofen für gerichtete Erstarrung von Kristallen, der einen Tiegel (7) aufweist, wobei der Tiegel vorgesehen ist, um Kristalle zu enthalten, und wobei er eine Symmetrieachse (Δ1) aufweist, wobei der Ofen in aufeinanderfolgender Weise entlang der Symmetrieachse (Δ1) Folgendes aufweist:
den Tiegel (7);
Heizelemente (21);
zwei erste Verschlüsse (32a, 32b), die in einer ersten Ebene angeordnet sind, die durch Translationsbewegungen zueinander hin oder voneinander weg und zur Symmetrieachse hin oder weg von dieser zu gleiten;
zwei zweite Verschlüsse (34c, 34d), die in einer zweiten Ebene gelegen sind, die durch Translationsbewegungen zueinander hin oder voneinander weg und zu der Symmetrieachse (Δ1) hin und weg von dieser gleiten können, wobei die Translationsrichtungen der ersten Verschlüsse (32a, 32b) und der zweiten Verschlüsse (34c, 34d) orthogonal sind, wobei die ersten und zweiten Verschlüsse (32a, 32b, 34c, 34d) zusammen eine Wärmeabschirmung (29) bilden;
ein Antriebssystem, welches fähig ist, die ersten und zweiten Verschlüsse (32a, 32b, 34c, 34d) zueinander hin und weg voneinander zu schieben, welches einen Antriebsteil (53) aufweist, der mit jedem der ersten und zweiten Verschlüsse (32a, 32b, 34c, 34d) über eine Verbindungsstange (57a bis 57d) verbunden ist, welche bezüglich des Antriebsteils (53) und bezüglich des assoziierten ersten oder zweiten Verschlusses gelenkartig angeschlossen ist, wobei das Antriebssystem weiter einen Motor (67) aufweist, der fähig ist, den Antriebsteil (53) um die Symmetrieachse (Δ1) zu drehen; und
einen Wärmetauscher (27).

2. Ofen nach Anspruch 1, wobei die Wärmeabschirmung (29)Träger (41a bis 41d) aufweist, wobei jeder der ersten und zweiten Verschlüsse (32a, 32b, 34c, 34d) an einem Träger angebracht ist, wobei die Träger auf einer Platte (37) gleiten können, die zwischen den Verschlüssen und dem Wärmetauscher (27) angeordnet ist.

3. Ofen nach Anspruch 2, wobei die ersten Verschlüsse (32a, 32b) am nächsten zueinander sind, und wobei die zweiten Verschlüsse (34c, 34d) am nächsten zueinander sind, wobei jeder zweite Verschluss (34c, 34d) zumindest teilweise zwischen jedem ersten Verschluss (32a, 32b) und dem assoziierten Träger (41a, 41b) positioniert ist.

4. Ofen nach Anspruch 2 oder 3, wobei jeder erste und zweite Verschluss (32a, 32b, 34c, 34d) eine rechteckige Form hat, und wobei jeder Träger (41a bis 41d) einen spitzen Teil (42a bis 42d) aufweist, der zu der Symmetrieachse (Δ1) gerichtet ist.

5. Ofen nach Anspruch 4, wobei die ersten und zweiten Verschlüsse (32a, 32b) in Kontakt miteinander kommen können, und wobei die zweiten Verschlüsse (34c, 34d) in Kontakt miteinander kommen können, und wobei eine Seite des spitzen Teils (42a, 42b) von einem der Träger (41a, 41b), der mit den ersten Verschlüssen assoziiert ist, in Kontakt mit einer Seite des spitzen Teils (42c, 42d) von einem der Träger (41c, 41d) kommen kann, die mit den zweiten Verschlüssen assoziiert sind.

6. Ofen nach Anspruch 2, wobei jeder erste Verschluss (32a, 32b) von dem assoziierten Träger (41a, 41b) um eine Distanz gleich der Dicke von einem der zweiten Verschlüsse (34c, 34d) durch Beabstandungselemente (35a, 35b, 45a, 45b) beabstandet ist.

7. Ofen nach Anspruch 6, wobei für jeden ersten Verschluss (32a, 32b) die Beabstandungselemente einen Abstandshalter (35a, 35b) aufweisen, der die Kante des ersten Verschlusses, der am weitesten entfernt von der Symmetrieachse (Δ1) ist, und den assoziierten Träger (41a, 41b) verbindet, und eine Stange (45a, 45b), welche die Kante des ersten Verschlusses, der am nächsten zur Symmetrieachse ist, und den spitzen Teil (42a, 42b) des assoziierten Trägers verbindet, und wobei jeder zweite Verschluss (34c, 34d) Öffnungen (47c, 47d, 48c, 48d) aufweist, welche die Stangen aufnehmen können, wenn die Verschlüsse am nächsten aneinander sind.

8. Ofen nach einem der Ansprüche 1 bis 7, wobei der Wärmetauscher (27) zwischen den ersten und zweiten Verschlüssen auf der einen Seite und zumindest einem Teil des Antriebssystems auf der anderen Seite angeordnet ist.

9. Ofen nach einem der Ansprüche 1 bis 8, der weiter für jeden ersten und zweiten Verschluss (32a, 32b, 34c, 34d) einen langgestreckten Verbindungsteil (59a bis 59d) aufweist, der an der Kante des assoziierten ersten oder zweiten Verschlusses befestigt ist, der am weitesten entfernt von der Symmetrieachse (Δ1) ist, wobei der langgestreckte Teil entlang einer Richtung parallel zur Symmetrieachse gerichtet ist, und wobei die Verbindungsstange (57a bis 57d) bezüglich des Verbindungsteils und bezüglich des Antriebsteils (53) gelenkartig angeschlossen ist und entlang einer Richtung senkrecht zur Symmetrieachse gerichtet ist.

10. Verfahren zur Herstellung eines Barrens eines Kristallmaterials unter Verwendung des Ofens nach einem der Ansprüche 1 bis 9, welches folgende Schritte aufweist:
a) Einführen von Materialchips in den Tiegel (7);
b) Schmelzen der Materialchips mittels der Heizelemente (21), wobei die ersten Verschlüsse (32a, 32b) am nächsten zueinander hingebracht sind, und wobei die zweiten Verschlüsse (34c, 34d) am nächsten zueinander hingebracht sind;
c) Abkühlen des geschmolzenen Materials durch den Wärmetauscher (27) durch Wegschieben der ersten Verschlüsse (32a, 32b) voneinander und durch Wegschieben der zweiten Verschlüsse (34c, 34d) voneinander, damit sich das geschmolzene Material verfestigt, um den Barren zu formen.

11. Verfahren nach Anspruch 10, wobei:
im Schritt a) Einkristall-Keime in dem Tiegel (7) zusätzlich zu den Materialchips eingeleitet werden, und wobei zumindest ein Teil der Einkristall-Keime nicht beim Schritt b) schmilzt; und
beim Schritt c) die Verfestigung des geschmolzenen Materials von dem Teil der Einkristall-Siliziumkeime beginnt, der nicht im Schritt b) geschmolzen ist.

## Claims

1. A directional crystal solidification furnace comprising a crucible (7), the crucible being intended to contain the crystals and comprising an axis of symmetry (Δ1), the furnace successively comprising, along the axis of symmetry (Δ1) :
the crucible (7);
heating elements (21);
two first shutters (32a, 32b), located in a first plane, capable of shifting away from or back towards each other and the axis of symmetry by translational motions;
two second shutters (34c, 34d), located in a second plane, capable of shifting away from or back towards each other and the axis of symmetry (Δ1) by translational motions, the translational directions of the first shutters (32a, 32b) and of the second shutters (34c, 34d) being orthogonal, the first and second shutters (32a, 32b, 34c, 34d) altogether forming a heat shield (29);
a drive system capable of shifting away and back together the first and second shutters (32a, 32b, 34c, 34d), comprising a drive part (53) connected to each first and second shutter (32a, 32b, 34c, 34d) via a connecting rod (57a to 57d) articulated with respect to the drive part (53) and with respect to the associated first or second shutter, the drive system further comprising a motor (67) capable of rotating the drive part (53) around the axis of symmetry (Δ1); and
a heat exchanger (27).

2. The furnace of claim 1, wherein the heat shield (29) comprises supports (41a to 41d), each first and second shutter (32a, 32b, 34c, 34d) being attached to a support, the supports being capable of sliding on a plate (37) arranged between the shutters and the heat exchanger (27).

3. The furnace of claim 2, wherein, when the first shutters (32a, 32b) are at closest to each other and the second shutters (34c, 34d) are at closest to each other, each second shutter (34c, 34d) is at least partly positioned between each first shutter (32a, 32b) and the associated support (41a, 41b).

4. The furnace of claim 2 or 3, wherein each first and second shutter (32a, 32b, 34c, 34d) has a rectangular shape and each support (41a to 41d) comprises a pointed portion (42a to 42d) directed towards the axis of symmetry (Δ1).

5. The furnace of claim 4, wherein the first shutters (32a, 32b) are capable of coming into contact with each other and the second shutters (34c, 34d) are capable of coming into contact with each other, and wherein a side of the pointed portion (42a, 42b) of one of the supports (41a, 41b) associated with the first shutters is capable of coming into contact with a side of the pointed portion (42c, 42d) of one of the supports (41c, 41d) associated with the second shutters.

6. The furnace of claim 2, wherein each first shutter (32a, 32b) is spaced apart from the associated support (41a, 41b), by a distance equal to the thickness of one of the second shutters (34c, 34d), by spacing elements (35a, 35b, 45a, 45b).

7. The furnace of claim 6, wherein, for each first shutter (32a, 32b), the spacing elements comprise a spacer (35a, 35b) connecting the edge of the first shutter which is most remote from the axis of symmetry (Δ1) and the associated support (41a, 41b), and a rod (45a, 45b) connecting the edge of the first shutter closest to the axis of the symmetry and the pointed portion (42a, 42b) of the associated support, and wherein each second shutter (34c, 34d) comprises openings (47c, 47d, 48c, 48d) capable of receiving the rods when the shutters are at closest to each other.

8. The furnace of any of claims 1 to 7, wherein the heat exchanger (27) is arranged between the first and second shutters on the one hand, and at least a portion of the drive system on the other hand.

9. The furnace of any of claims 1 to 8, further comprising, for each first and second shutter (32a, 32b, 34c, 34d), an elongated connection part (59a to 59d) fastened to the edge of the associated first or second shutter most remote from the axis of symmetry (Δ1), the elongated connection part being directed along a direction parallel to the axis of symmetry, and the connecting rod (57a to 57d) being articulated with respect to the connection part and with respect to the drive part (53) and directed along a direction orthogonal to the axis of symmetry.

10. A method for manufacturing an ingot of a crystal material using the furnace of any of claims 1 to 9, comprising the steps of:
a) introducing chips of the material into the crucible (7);
b) melting the chips of the material by means of the heating elements (21), the first shutters (32a, 32b) being brought at closest to each other and the second shutters (34c, 34d) being brought at closest to each other;
c) cooling the molten material by means of the heat exchanger (27) by shifting away the first shutters (32a, 32b) from each other and the second shutters (34c, 34d) from each other, to have the molten material solidify and form the ingot.

11. The method of claim 10, wherein:
at step a), single-crystal seeds are introduced into the crucible (7) in addition to the chips of the material, and at least a portion of the single-crystal seeds do not melt at step b); and
at step c), the solidification of the molten material is started from the portion of the single-crystal silicon seeds which has not melted at step b).
